# EUROPEAN PATENT SPECIFICATION

(11) **EP 4 386 404 B1**
(45) Date of publication and mention of the grant of the patent: **06.05.2026**
(21) Application number: 22213888.5
(22) Date of filing: 15.12.2022
(51) Int. Cl.: G01R 31/378, G01R 31/36, G01R 31/3828, G01R 31/382, G01R 31/374, G01R 22/10

(54) **CONSUMPTION METER AND CONSUMPTION METER SYSTEM**
VERBRAUCHSZÄHLER UND VERBRAUCHSZÄHLERSYSTEM
COMPTEUR DE CONSOMMATION ET SYSTÈME DE COMPTEUR DE CONSOMMATION

(43) Date of publication of application: 19.06.2024
(73) Proprietor: Kamstrup A/S, 8660 Skanderborg (DK)
(72) Inventor: Jensen, Mads Erik Lund, 8660 Skanderborg (DK); Savolainen, Juha-Matti, 8660 Skanderborg (DK)
(74) Representative: Patentanwälte Hemmer Lindfeld Frese Partnerschaft mbB

(56) References cited:
- CN-A- 113 447 830
- JP-A- 2021 179 397
- CHRISTOPHER OSTERLOH, CHRISTOPHER NAGY, THIERRY CHATROUX: "USAGE BASED LOW BATTERY INDICATION METHOD AND SYSTEM", IP.COM, IP.COM INC., WEST HENRIETTA, NY, US, 23 June 2004 (2004-06-23), XP013020681, ISSN: 1533-0001

## Description

The present invention is directed to a consumption meter comprising a battery for energy supply and an accumulation module. The invention is further directed to a consumption meter system comprising a consumption meter and a battery lifetime estimation module.

Consumption meters for measuring the consumption of, for example, heat, cooling liquid, gas or water are well-known in the prior art. Originally, these meters were purely mechanical meters. However, today's meters operate electronically and thus require a power source such as a battery. The battery may be used to power the actual metering circuitry which measures the consumption. Further, the battery may be provided to power a display which shows the current status of the meter and, in particular, the consumption of water, heat or cooling liquid measured by the meter. Further, the battery may also be used to power a communications module in case that the measured values shall be transmitted to a remote receiver.

Consumption meters are usually left in place at the metering side for a long time, for example, several years or even more than a decade. During this time, the battery is never replaced. Thus, any battery serving as the power source in the consumption meter has to be highly reliable and have a low self-discharge. Certain battery types are particularly suitable for this kind of application.

Preferably, the battery technology provides a high energy density and a low leakage current. One example type of such a battery is a lithium thionyl chloride (Li-SOCl₂) battery. The disadvantage of these batteries is that the voltage supplied by the battery is not correlated with the remaining capacity as it is commonly known from batteries. Thus, contrary to conventional batteries it is not sufficient to measure the voltage across the battery to estimate the remaining capacity.

In order to ensure that the consumption meters always remain operational, it is important that the meter's battery is exchanged in due time. Thus, accurately determining or estimating the remaining capacity or lifetime of the battery is important. Given that the battery is the only means of powering the meter, estimating the remaining battery capacity should be made with as little impact as possible on the battery runtime.

JP 2021 179397 A discloses a battery life prediction system for lithium thionyl chloride batteries. The battery capacity is estimated based on a current consumption value which is calculated by summing up the product of the operating time of every operation and the current consumed per hour for that operation.

Christopher Osterloh, et al. "Usage based low battery indication method and system", IP.COM, IP.COM.INC, West Henrietta, N.Y. discloses a method for determining the coulomb consumption and remaining coulomb capacity of a battery. The remaining capacity of the battery is calculated by subtracting the consumed coulomb over the battery life from the initial coulomb capacity. The coulomb consumption is determined by tracking the operation, the duration of an operation mode, and the temperature of the device.

CN 113 447 830 A discloses a method for estimating the remaining battery capacity of a lithium battery. The capacity is estimated based on the current use for every working cycle which is multiplied by the number of times the working cycle is operated.

Hence, it is an object of the present invention to provide a consumption meter as well as a consumption meter system comprising a consumption meter which enables accurately estimating the remaining battery lifetime of the battery used in the meter while keeping the overall battery consumption as low as possible.

The problem underlying the present invention is solved by a consumption meter according to independent claim 1 as well as a consumption meter system according to claim 6. Preferred embodiments of the invention are described in the dependent claims.

In a first aspect a consumption meter comprising a battery for energy supply and an accumulation module is provided. The accumulation module is configured for accumulating a first quantity over a time period to obtain a first accumulated quantity. The first accumulated quantity is based on a product of a current drawn from the battery and a duration over which the current was drawn from the battery. The accumulation module is further configured for transmitting the first accumulated quantity at regular or irregular intervals to a battery lifetime estimation module for calculating a remaining battery lifetime based on a nominal battery capacity, the received first accumulated quantity and an operating time of the battery.

In other words, the consumption meter or short meter comprises at least a battery and an accumulation module. The battery supplies the energy required for operating the meter, e.g., for powering the metering circuitry and the accumulation module. The accumulation module is used to determine at least a first quantity representing a consumption or use of battery capacity by the meter. The first quantity is provided by the accumulation module to a battery lifetime estimation module for estimating the remaining lifetime of the battery.

The first quantity that is representative or indicative of the battery capacity used by the meter over time is based on a product of a current drawn from the battery and a time period over which the current is drawn from the battery. For example, the first quantity may be product of the current drawn from the battery and the time for which the current was drawn from the battery. Alternatively, the first quantity may be the product of the electric power supplied by the battery and the time over which the respective electric power was supplied by the battery, i.e., in the alternative the first quantity is the product of time, current and voltage. The latter corresponds to the electric energy provided by the power source to the meter, i.e., the first quantity may also be the electric power used by the meter over a time period.

The accumulation module does not simply provide the first quantity to the battery lifetime estimation module but accumulates a plurality of values of the first quantity and transmits the obtained accumulated first quantity at certain intervals to the battery lifetime estimation module. In other words, it is understood that the first accumulated quantity is obtained by adding at least two values of the first quantity, i.e., transmitting a single first quantity does not constitute transmitting a first accumulated quantity. Hence, two or more and preferably a plurality of first quantities indicating a reduction of the remaining battery capacity are summed up by the accumulation module and may, for example, be stored in a memory or register of the meter as a first accumulated quantity.

This first accumulated quantity is transmitted at various regular or irregular intervals to a battery lifetime estimation module where a remaining battery lifetime is calculated as will be set out below in more detail with regard to the exemplary embodiments of a consumption meter system comprising a consumption meter and a battery lifetime estimation module. Transmission of the first accumulated quantity may be initiated by the accumulation module at its own volition, for example, after a given period of time since the last transmission has expired. Hence, the meter pushes the first quantity at regular or irregular intervals to the battery lifetime estimation module. However, it is also possible to configure a meter so that it is able to receive a request from another entity, for example, the battery lifetime estimation module to transmit the first accumulated quantity. Hence, the transmission would be triggered by the other entity and the first accumulated quantity is essentially pulled from the meter.

Determining a first quantity which is based on a product of current and time, accumulating the first quantity to obtain a first accumulated quantity and transmitting this first accumulated has several advantages. Firstly, no individual values indicative of the power consumed from the battery by the meter have to be transmitted to the battery lifetime estimation module. Since the values are summed-up, a single transmission (of a single value) per (regular or irregular transmission) interval is sufficient. Further, since the first quantity is based on the product of current and time, it is also not necessary to transmit the time over which the power was drawn from the battery for estimating the power consumption. This value is already included in the transmitted first accumulated quantity. Hence, the number of values that need to be transmitted is further reduced which improves the battery lifetime.

At the battery lifetime estimation module, a remaining battery lifetime is calculated based on the nominal battery capacity, the first accumulated quantity that was received by the battery lifetime estimation module as well as an operating time of the battery. The nominal battery capacity could, for example, be a battery capacity indicated by a producer of the battery or an average battery capacity determined from a sample set of batteries. Specific ways of calculating the remaining battery lifetime are described in further detail as part of exemplarily embodiments.

In an exemplary preferred embodiment, the first quantity is based on a product of at least the current drawn from the battery and the duration over which the current was drawn from the battery as well as preferably also a voltage at which the current was supplied from the battery. For example, the first quantity could be the electrical energy drawn from the battery. Hence, the first accumulated quantity could be the electrical energy drawn from the battery between two instances at which the first quantity is transmitted from the accumulation module to the battery lifetime estimation module. The energy could, for example be measured in milliwatt hours.

In a further preferred embodiment, the accumulation module is configured for estimating the first quantity based on an operation of the consumption meter. Thus, instead of actually measuring the current that is drawn from the battery, the accumulation module could be configured for counting different types or kinds of operation of the meter. For example, if the meter is a flow meter, the meter could have a memory in which the current required for a single metering operation is stored. Additionally, for those operations which take a fixed amount of time such a as a measuring operation, also the time over which the metering operation occurs may be stored in a memory of the consumption meter. The accumulation module would only count the number of times a given operation is performed by the meter and may have to measure or calculate the time for which an operation is performed. An example for an operation with different durations may be a transmission time when using the LTE NB-IOT protocol where the transmission time depends on connection properties. Alternatively, the memory could also store a first quantity for each operation, for example, the product of current and time required for performing a specific operation when the time required for performing the operation is fixed.

The first accumulated quantity would thus be obtained by summing up the stored values for each operation that is performed by the meter. The accumulation could be performed continuously, i.e., whenever the meter performs an operation the respective first quantity is added to the accumulated first quantity. However, it is also possible that the accumulation is performed only when a transmission of the first accumulated quantity is intended i.e., whenever a regular or irregular interval has passed after which the first accumulated quantity shall be transmitted to a battery lifetime estimation module.

Adding prestored first quantities or obtaining the first quantities from prestored values, such as known current consumptions and the time required to perform an operation, based on the number of times an operation is performed is preferred as no measurements of the actual current consumption from the battery have to be performed. Since the reduction in battery capacity does usually not change for metering operations over time, no repetitive measurements have to be performed.

However, in an alternative embodiment, the meter comprises means for measuring the current drawn from the battery. Preferably, the meter further comprises means for measuring a voltage at which the current is supplied and/or means for determining a duration or time over which the respective current is drawn from the battery. Measuring the current drawn from the battery and preferably also the voltage at which the current is supplied and/or the duration for which the current is drawn from the battery enables a more accurate estimate of the remaining battery runtime or capacity. However, this comes at the cost of a reduced battery lifetime by itself as the measuring of the current and potentially the voltage and the corresponding time uses a non-neglectable amount of battery capacity. Nevertheless, in certain cases where the meter operation is highly irregular and a particularly accurate estimate is more relevant than a longer battery lifetime, actively measuring the current and preferably also the voltage at which the current is supplied or the time for which the current is supplied may nevertheless be preferred.

The consumption meter further comprises a temperature sensor. A temperature sensed by the temperature sensor may be used to improve the accuracy of the estimated battery lifetime as set out below. The temperature sensor is in an exemplary preferred embodiment placed inside the housing of the meter and could, for example, be part of a microcontroller which is used to implement the accumulation module or be placed on a printed circuit board (PCB) which supports the electronics of the consumption meter. A temperature sensed by the temperature sensor could, for example, be used to improve an estimate of the self-discharge of the meter's battery or be used to correct the current-consumption of the meter for temperature effects.

The accumulation module is further configured for accumulating a second quantity over a time period to obtain a second accumulated quantity. The second quantity is a product of a temperature at the meter and the duration for which the temperature was observed. The accumulation module is further configured for transmitting the second accumulated quantity to the battery lifetime estimation module for calculating a remaining battery lifetime additionally based on the received second accumulated quantity.

Hence, the accumulation module of the consumption meter also sums up a second quantity. This second quantity is based on the product of a temperature at the meter and the duration for which the temperature was observed. The temperature sensor may be used to measure the temperature in the meter in temperature measurement intervals of between and including 30 seconds and 60 minutes, e.g., the temperature measurement intervals may be 30 seconds, 60 seconds, 5 minutes, 10 minute, 30 minutes or 60 minutes. The accumulation modules assume that the temperature was constant between subsequent temperature measurements, i.e., over the respective temperature measurement interval, , i.e., it assumes the same temperature would be observed for the respective temperature measurement interval.

Then the product of the temperature and the temperature measurement interval is added to the second accumulated quantity. After the second quantity has been accumulated for a certain time period of, for example, 6 hours, 12 hours or 24 hours, the accumulation module transmits the second accumulated quantity to the battery lifetime estimation module. Again, it is understood that the accumulation module at least adds two second quantities to obtain the second accumulated quantity. Preferably, a plurality of second quantities are summed-up to obtain the second accumulated quantity. For example, a temperature may be measured every 2 minutes and the first accumulated quantity is transmitted to the battery lifetime estimation module every twelve hours. Thus, at least 360 second quantities, each being formed by a measured temperature times twelve hours, are added-up by the accumulation module and transmitted as the second accumulated quantity.

The second quantity is then transmitted at regular or irregular intervals from the accumulation module to the battery lifetime estimation module. The intervals are the same or different intervals as the intervals at which the first accumulated quantity is transmitted to the battery lifetime estimation module.

At the battery lifetime estimation module, the second accumulated quantity, i.e., the product of the temperature at the meter and the time is taken into consideration when calculating the remaining battery lifetime. Taking the temperature at the meter into consideration when determining the remaining battery lifetime improves the estimate of the remaining battery lifetime since the self-discharge of the battery of the meter as well as the current consumption of the electronics depends on the temperature at the meter.

In a preferred embodiment, the accumulation module is configured for determining the first quantity based on a temperature sensed by the temperature sensor. In other words, when the first quantity is determined by counting the number an operation is performed or carried out by the meter, the first quantity retrieved by the accumulation module from the memory may either be temperature dependent or may be corrected for temperature. For example, the memory could store different first quantities for each operation depending on the temperature inside the meter or the accumulation module could be configured to apply a temperature correction to a first quantity retrieved from the memory to account for temperature dependence of the current consumption.

Preferably, the first and/or second accumulated quantity is not reset after the respective first and/or second accumulated quantity is transmitted but the accumulation of the first and/or second quantity continues after transmission of the respective first accumulated quantity and/or the respective second accumulated quantity. In other words, the accumulation of the first and/or second quantities is not restricted to the time interval between two subsequent transmissions of the first and/or the second quantity to the battery lifetime estimation unit. Rather, the first and/or the second quantity are continuously accumulated over extended periods of time and the value accumulated over these extended periods of time is transmitted.

By continuously accumulating the first and/or the second quantity, it is ensured that the battery lifetime estimation module can estimate the remaining battery lifetime even in case individual transmissions of the first and/or the second accumulated quantity are not received at the battery lifetime estimation module. Due to the location where consumption meters are often placed, (wireless) transmissions between the accumulation module and the battery lifetime estimation module are often distorted. Transmissions of the first and/or second accumulated quantities are therefore often not received or the received part of the transmission is corrupted so that the battery lifetime estimation module misses one or more transmitted accumulated quantities. By continuously accumulating the first and/or second quantity, missing one or more transmissions of the accumulated values does not impact the calculation of the remaining battery lifetime estimation module when a subsequent transmission is received. Since the accumulation continues after the transmission, the missed accumulated quantities are inherently included in the subsequent transmission.

In a preferred embodiment, the accumulation module is configured for accumulating the one or more quantities from the time the battery is initially placed in the meter until the battery is removed from the meter. Hence, in the preferred embodiment the memory or register used in the consumption meter for storing the first and/or second accumulated quantity is not reset after every transmission of the first and/or second accumulated quantity but is maintained until the battery is replaced. The first and/or second accumulated quantity would thus be reset or zeroed whenever the battery is replaced. This ensures that the first and/or second accumulated quantity received by the battery lifetime estimation module applies only to the current battery and no first and/or second accumulated quantities accumulated quantities recorded when another battery was in place affects the estimation of the remaining battery lifetime.

Alternatively, the accumulation module is configured for accumulating the one or more quantities over the entire lifetime of the consumption meter. Hence, in the exemplary embodiment a persistent memory may be used which keeps its values stored even when the meter is not powered or switched off and simply adds the newly recorded first and/or second quantities to the current value of the first and/or second accumulated quantity. The first and/or the second quantity could, thus, be accumulated over the entire lifetime of the consumption meter. It should be noted that in this case it is essential for the battery lifetime estimation module to be at least aware of the time at which the current battery was placed in the meter and the value of the first and/or second accumulated quantity when the current battery was placed in the meter.

Therefore, it is preferable that the accumulation module in configured for transmitting a time at which the battery of the meter is changed to the battery lifetime estimation module. The accumulation module of the preferred embodiment is thus configured to create a timestamp when a new battery is placed in the meter. The timestamp is transmitted to the battery lifetime estimation module. This enables the battery lifetime estimation module to exclude any transmission of the first accumulated quantity and/or the second accumulated quantity from the battery lifetime estimation module that was received or recorded before the time at which the current battery was placed in the meter. Hence, only those first and/or second accumulated quantities received after the time or at least during a time span after the time at which the battery was placed in the meter will be considered for estimating the remaining battery lifetime of the current battery.

Preferably, the accumulation module is configured for transmitting the one or more accumulated quantities over a wireless connection or a wired connection to the battery lifetime estimation module. For example, the first and/or the second accumulated quantity can be transmitted using a wireless communication protocol to a remotely located battery lifetime estimation module. In an alternative embodiment, a wired connection is used for transmitting the accumulated quantities to the battery lifetime estimation module. The latter is particularly preferred, if the battery lifetime estimation module is located in the same housing as the consumption meter, i.e., in case the battery lifetime estimation module is directly connected to the consumption meter.

In a second aspect the problem underlying the present invention is solved by a consumption meter system comprising a consumption meter according to any of the preceding embodiments and a battery lifetime estimation module. The battery lifetime estimation module is configured for receiving the first accumulated quantity from the accumulation module and calculating a remaining battery lifetime on basis of a nominal battery capacity, the received first accumulated quantity and an overall operating time of the battery.

In other words, in a second aspect a consumption meter system is provided which comprises a consumption meter and a battery lifetime estimation module. The system can be formed by a consumption meter and a remaining battery lifetime estimation module located in the same housing or by a battery lifetime estimation module and a consumption meter according to any of the preceding embodiments located remotely from each other.

In any case, the first accumulated quantity and also the second accumulated quantity are transmitted from the accumulation module to the remaining battery lifetime estimation module. Here, the actual remaining battery lifetime is estimated based on factors including at least a nominal battery capacity, i.e., the expected battery capacity, the received first accumulated quantity, and an overall operating time of the battery. For example, the remaining battery lifetime could be estimated by subtracting the received first accumulated quantity from the nominal battery capacity provided that both are given in the same dimension to estimate a remaining battery capacity.

It is further preferred that the battery lifetime estimation module is configured for calculating the remaining battery lifetime by subtracting the first accumulated quantity last received from an available battery capacity to obtain the remaining battery capacity. The remaining battery lifetime is estimated by dividing the remaining battery capacity by an expected future discharge of the battery.

In other words, the remaining battery capacity is preferably divided by an estimated future battery use or expected future discharge to obtain a remaining battery lifetime. The expected future discharge can, for example, be estimated based on the overall operating time of the battery and the last received first accumulated quantity as explained below in further detail. Also, if provided, the second accumulated quantity could also be taken into consideration to account for future discharge when estimating the future battery use. Future battery usage could, for example, be estimated per hour, per day, per week or per month.

It should be noted that in case the accumulation module does not reset the accumulation of the first quantity when a battery is placed in the meter, it may be necessary to correct the last received first accumulated quantity for any values that were already accumulated for another battery. This could be achieved, for example, by subtracting the first accumulated quantity that was last received from the meter before the current battery was placed in the meter or by subtracting the first accumulated quantity that was received from the accumulation module after the current battery had been placed in the meter.

It is further preferred that the battery lifetime estimation module is configured for estimating the available battery capacity by applying a correction factor to the nominal battery capacity. The battery lifetime estimation module is preferably configured for calculating an average current drawn from the battery based on the received first accumulated quantity and determining the correction factor for estimating the available battery capacity based on a calculated average current. Alternatively, or additionally the battery lifetime estimation module is preferably configured for determining the correction factor based on a peak current drawn from the battery.

The correction factor is applied to the nominal battery capacity to correct for a self-discharge of the battery. The amount of self-discharge of batteries depends on the type of battery used and is affected by a variety of different variables such as, for example, the peak current drawn from the battery. For example, self-discharge of a lithium thionyl chloride battery increases with the peak current drawn from the battery.

Generally, the energy consumption caused by the operation of the consumption meter is highly variable. Periods of low to no energy consumption when the meter rests are interrupted by periods of high battery usage during which, for example, the meter measures consumption, a display of the meter is switched on or data such as accumulated quantities is transmitted from the meter to a battery lifetime estimation unit or another entity. In case the components of the meter are directly powered by the battery, this irregular battery usage would result in high peak currents that have to be observed and could, for example, either be measured or be retrieved from a memory in case the allowed operations are well-defined.

However, in a preferred embodiment the circuit supplying power from the battery to the metering circuit is designed to limit the peak current to a predefined maximum value. Here, a capacitor that is charged via a serial resistor is provided. The capacitor is charged slowly and constantly using the battery and in turn used to provide the high amounts of charge required to power individual operations of the meter. Hence, in this or a similar scenario a fixed maximum peak current could be employed by the meter as the battery is essentially only used to charge the capacitor.

Similarly, also the average current drawn from the battery affects the self-discharge of the battery. Therefore, the average current which can be calculated using the first accumulated quantity is considered to determine the correction factor which is applied to the nominal battery capacity.

In a preferred embodiment the battery lifetime estimation module is configured for receiving the second accumulated quantity from the accumulation module and calculating a remaining battery lifetime also on basis of the received second accumulated quantity. Hence, in the preferred embodiment the battery lifetime estimation module also considers the temperatures measured at the meter to improve the estimate of the remaining battery lifetime.

Preferably, the battery lifetime estimation module is configured for obtaining the correction factor based on the received second accumulated quantity as the temperature at the location of the meter primarily effects the self-discharge of the battery. Additionally or alternatively, the battery lifetime estimation module is preferably configured for correcting a received first accumulate value based on a received second accumulated value to account for temperature-dependent current consumption at the meter.

In a preferred embodiment the battery lifetime estimation module is configured for calculating the correction factor based on all second accumulated quantities received since the battery has been placed in the meter. For example, the correction factor could be determined based on the overall average temperature measured at the location of the meter. However, it is preferred to use the separate or individual received values of the second accumulated quantity to determine the correction factor. For example, the difference between subsequent received second accumulated quantities could be considered to represent the (average) temperature at the meter between the subsequent transmission. The correction factor could then be estimated based on the distribution of temperatures at the meter, i.e., instead of relying on an overall average temperature, the self-discharge at the meter would be estimated based on the number of times or the overall duration each average temperature was recorded for the meter.

The battery lifetime estimation module is further configured for estimating the expected future discharge based on at least some of the received first accumulated quantities and preferably by estimating the expected future discharge from selected received first accumulated quantities. Hence, it is assumed that at least some of the received first accumulated quantities could be considered representative for a future use of the battery at the consumption meter. For example, all received first quantities could be considered to estimate the future draining of the battery by operations of the meter. However, in some embodiments it may be useful to select some of the received first accumulated quantities and use these selected quantities to estimate the future discharge. For example, on the received first accumulated quantities of a given period, for example, the last 12 months may be used.

Correspondingly, the received second accumulated quantities can also be considered when estimating the expected future discharge of the battery. For example, the average temperature distribution over the last year may be considered to estimate the future self-discharge of the battery. In an alternate example, the distribution of the temperatures received for the last 12 months may be considered when estimating the expected future discharge.

Preferably, an average of at least some of the received first accumulated quantities is determined as the expected future discharge. The estimate is based on at least some, selected or all the received first accumulated quantities again assuming that the received first quantities are representative for a future consumption of battery capacity.

In a preferred embodiment, the battery lifetime estimation module is configured for excluding at least some of the received first and/or second accumulated quantities when estimating the expected future discharge. Hence, in the exemplary embodiments some received accumulated quantities are selectively not considered when calculating the expected future discharge. For example, any first and/or second accumulated quantities received while the meter was in storage or when the meter was located in a different metering location then the current metering location can be excluded from estimating the expected future discharge since these values are not expected to be relevant for the future operation or self-discharge at the current metering location. Also, when the meter is temporarily not used at a metering location but, for example, it is re-validated, the first and/or second accumulated quantities received during these times may be disregarded when estimating the expected future discharge.

In a preferred embodiment, the consumption meter and the battery lifetime estimation module are arranged in a same housing. In other words, the battery lifetime estimation module and the consumption meter are part of the same entity and co-located. In this example, the battery lifetime estimation module and the accumulation module may be implemented using the same integrated circuit, for example, an application specific integrated circuit (ASIC), a microprocessor or a microcontroller. Preferably, the modules would be implemented using software operating on the same microcontroller and the transmission of first and/or second accumulated quantities could be achieved using a storage in a memory of the device.

Alternatively, the battery lifetime estimation module is part of an external control device which is arranged remotely from the consumption meter. Hence, in the preferred embodiment the meter system comprises two separate and remote parts which may, for example, be connected via a wireless data communication link. Also, a wired connection between the remote parts is possible. The battery lifetime estimation module and the accumulation module could in this embodiment, for example, be formed by software operating on different hardware devices or by designated application specific integrated circuits (ASIC). For example, the accumulation module could be formed by software ule also by software running on a separate microcontroller.

Further preferably, the battery lifetime estimation module is configured to estimate the remaining battery lifetime of the batteries of a plurality of consumption meters. Hence, multiple meters transmit their data to a single battery lifetime estimation module which then calculates or estimates the battery lifetimes for each of the meters.

In a further exemplary aspect not forming part of the claimed subject-matter, a method for providing a first accumulated quantity which is indicative of a battery use at a consumption meter is provided. The method comprises at a consumption meter accumulating a first quantity over a time period to obtain a first accumulated quantity, wherein the first quantity is based on a product of at least a current drawn from the battery and a duration over which the current was drawn from the battery. The first accumulated quantity is transmitted at regular or irregular intervals to a battery lifetime estimation module for calculating a remaining battery lifetime on basis of a nominal battery capacity, the received first accumulated quantity and an operating time of the battery.

In an exemplary preferred embodiment not forming part of the claimed subject-matter, the first quantity is based on a product of the current drawn from the battery, the duration over which the current was drawn from the battery and a voltage at which the current was supplied from the battery.

In a further exemplary preferred embodiment not forming part of the claimed subject-matter, the first quantity is estimated based on an operation of the consumption meter or based on the measured current drawn from the battery. Further preferably, a voltage at which the current is supplied by the battery and/or the duration over which the current is drawn from the battery are also measured at the consumption meter.

In a further exemplary preferred embodiment not forming part of the claimed subject-matter, a temperature inside the meter is measured using a temperature sensor.

In a further exemplary preferred embodiment not forming part of the claimed subject-matter, a second quantity is accumulated over a time period to obtain a second accumulated quantity, wherein the second quantity is a product of a temperature at the meter and a duration for which the temperature was observed. The second accumulated quantity is preferably transmitted to the battery lifetime estimation module for calculating a remaining battery lifetime additionally on the basis of the received second accumulated quantity.

In a further preferred embodiment not forming part of the claimed subject-matter, the first quantity is determined based on a temperature sensed by the temperature sensor.

The one or more quantities are, for example, preferably accumulated from the time the battery is initially placed in the meter until the battery is removed from the meter or alternatively over the entire lifetime of the consumption meter.

For example, a time at which the battery of the consumption meter is replaced by a new battery is preferably transmitted to the battery lifetime estimation module. Further, in an exemplary preferred embodiment not forming part of the claimed subject-matter, the one or more accumulated quantities are transmitted over a wireless connection or a wired connection to the battery lifetime estimation module.

In a further exemplary aspect not forming part of the claimed subject-matter, a method for estimating a remaining battery lifetime is provided, the method comprising receiving the first accumulated quantity accumulated according to one of the preceding embodiments and calculating a remaining battery lifetime on basis of a nominal battery capacity, the received first accumulated quantity and an overall operating time of the battery.

In an exemplary preferred embodiment not forming part of the claimed subject-matter, the remaining battery lifetime is calculated by subtracting the first accumulated quantity last received from an available battery capacity to obtain a remaining battery capacity and estimating the remaining battery life by dividing the remaining battery capacity by an expected future discharge of the battery.

Preferably, the available battery capacity is estimated in the exemplary method by applying a correction factor to the nominal battery capacity. For example, an average current drawn from the battery can be calculated based on the received first accumulated quantity and the correction factor for estimating the available battery capacity is determined based on the calculated average current. Additionally or alternatively, the correction factor can be based on a peak current drawn from the battery.

In an exemplary preferred embodiment not forming part of the claimed subject-matter, the second accumulated quantity is received, and a remaining battery lifetime is calculated also on basis of the received second accumulated quantity.

For example, a received first accumulate value is corrected based on a received second accumulated value to account for temperature-dependent current consumption. Additionally or alternatively, the correction factor is determined or obtained based on the received second accumulated quantity

In particular, the correction factor can be based on all second accumulated quantities received since the battery has been placed in the meter. Preferably, the expected future discharge of the battery is estimated based on at least some of the received first accumulated quantities and further preferably from selected received first accumulated quantities, wherein further preferably an average of at least some of the received first accumulated quantities is determined.

In an exemplary preferred embodiment not forming part of the claimed subject-matter, at least some of the received first and/or second accumulated quantities are excluded when estimating the expected future discharge.

The advantages and particular details of the exemplary embodiments (not forming part of the claimed subject-matter) of a method for providing a first accumulated quantity and potentially also a second accumulated quantity for estimating a remaining battery lifetime of a consumption meter as well as of the exemplary embodiments (not forming part of the claimed subject-matter) of a method for estimating a remaining battery lifetime based on the second accumulated quantity correspond to those of the respective embodiments of a consumption meter and a consumption meter system having structural features that correspond to the method features of the methods.

In the following, exemplary embodiments of consumption meters as well as exemplary embodiments of consumption meters will be described with reference to the drawings. Further, exemplary embodiments (not forming part of the claimed subject-matter) of a method for providing a first and a second accumulated quantity as well as estimating a remaining battery lifetime will also be described with reference to the drawings, wherein
- Figure 1: shows a schematic drawing of a first exemplary embodiment of a consumption meter system comprising an exemplary embodiment of a consumption meter,
- Figure 2: shows a schematic drawing of a second exemplary embodiment of a consumption meter system comprising an exemplary embodiment of a consumption meter,
- Figure 3: shows a schematic drawing of an exemplary embodiment of a circuit for providing power from a battery in consumption meter,
- Figure 4: shows a further exemplary embodiment of a consumption meter system comprising multiple consumption meters, and
- Figure 5: shows a flow chart for an exemplary embodiment (not forming part of the claimed subject-matter) of c method for estimating a remaining battery lifetime including an exemplary embodiment of a method for providing a first and a second accumulated quantity.

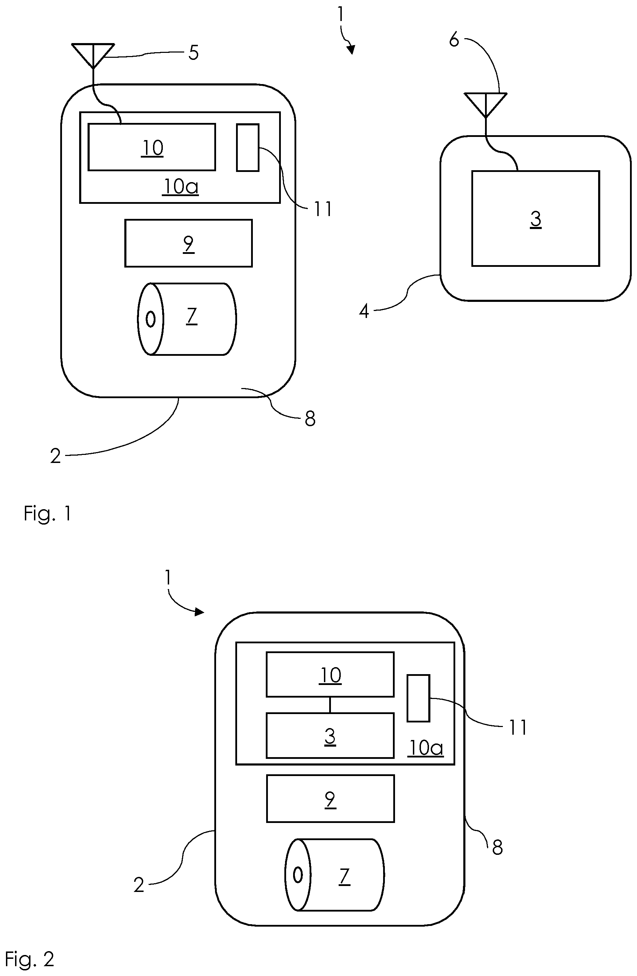

Figure 1 shows a schematic drawing of an exemplary embodiment of a consumption meter system 1 comprising a consumption meter 2 and a battery lifetime estimation module 3 located in a base station 4. The consumption meter 2 and the base station 4 each comprise an antenna 5, 6 enabling wireless data transmission from the consumption meter 2 to the base station 4. In the embodiment shown in Figure 1, the consumption meter 2 is only able to transmit data to the base station 4. However, it is also conceivable that the consumption meter 2 is configured for receiving data from the base station 4.

The distance between the consumption meter 2 and the base station 4 can be anything between a few meters and up to multiple kilometers depending on the communication protocol that is used to transmit data from the consumption meter 2 to the base station 4.

The consumption meter 2 is powered by a battery 7. In the exemplary embodiment shown in Figure 1, a lithium thionyl chloride battery is mounted in a housing 8 of the consumption meter 2. The battery 7 provides, in particular, power to metering circuitry 9 as well as an accumulation module 10. To keep the drawing simple, no connections are shown between the battery 7 and the units 9, 10 powered by the battery 7. In the exemplary embodiment shown in Figure 1, the accumulation module is implemented in software operating on a microcontroller 10a.

The consumption meter 2 further comprises a temperature sensor 11 for measuring the temperature inside the consumption meter. The temperature sensor 11 is implemented as part of the microcontroller 10a and thus also powered by the battery 7. Measured temperature values are available to the accumulation module 10.

The battery 7 may also be used to power further circuity and integrated circuits in the consumption meter which may or may not be part of the metering circuitry 9 such as a display and a transmitter for transmitting data from the consumption meter 2 to the base station 4. These and further components of the consumption meter 2 are not shown in the drawings. In the context of the present invention, they merely represent additional battery capacity consumers which can are treated in the same way as the metering circuitry 9.

An alternative embodiment of a consumption meter system 1 is shown in Figure 2. In Figure 2, elements designated in the same way as in Figure 1 are indicated with the same reference numerals. Only those aspects of the consumption meter system 1 that differ from the system 1 shown in Figure 1 will be discussed in more detail below.

The consumption meter system 1 shown in Figure 2 is formed as single unit, i.e., the battery 7, the metering circuitry 9, the accumulation module 10, the temperature sensor 11 and the battery lifetime estimation module 3 are all located in the same housing 8. The accumulation module 10 and the battery lifetime estimation module 3 are formed as software operating on a microcontroller 10a and the temperature sensor 11 is implemented as part of the microcontroller 10a.

The consumption meter 2 with its battery 7, the metering circuity 9, the accumulation module 10 and the temperature sensor 11 can from the outside not be distinguished from the consumption meter system 1. Therefore, the entire system 1 shown in Figure 2 could also be referred to as a consumption meter 2.

In the embodiment shown in Figure 2, the battery lifetime estimation module 3 and the accumulation module 10 are provided in the same housing 8. Hence, no wireless data communication between the two modules 3, 10 is necessary. Instead, data may be exchanged between the two modules using a wired connection. As discussed, in the exemplary embodiment in Figure 2, the accumulation module 10 and the battery life estimation module 3 are implemented as software modules operating on the microcontroller 10a. Data exchange between the two modules 3, 10 is performed by storing information in a memory of the microcontroller, for example, a cache, a random access memory or a persistent memory or in other ways well-known to the skilled person.

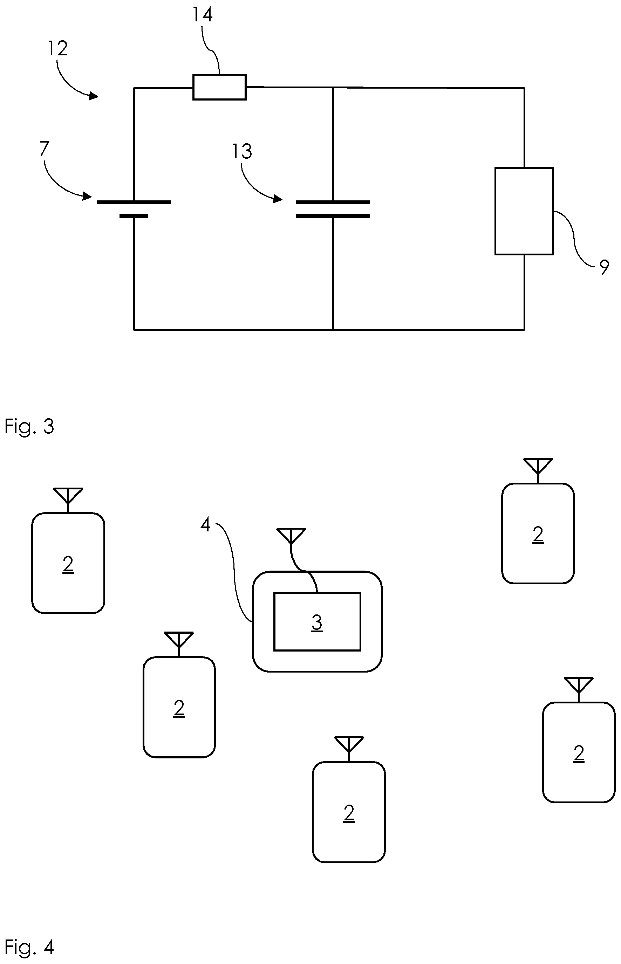

Figure 3 shows a schematic diagram of a circuit 12 used for supplying a current from the battery 7 to the metering circuitry 9 in the exemplary embodiments of a consumption meter 2 shown in Figures 1 and 2. The circuit 12 is in particular suitable for providing a current from a lithium thionyl chloride battery 7. As previously discussed, self-discharge of lithium thionyl chloride batteries depends on the peak current that is drawn from the battery 7. The lower the peak current, the smaller the self-discharge. Since batteries 7 in consumption meters 2 have to provide power to the meter 2 for periods of up to 16 years, low self-discharge is essential for achieving continuous operation for these long periods of time.

To minimize the peak currents and thereby the self-discharge of the battery 7, the circuit 12 shown in Figure 3 comprises a capacitor 13 connected via a serial resistor 14 to the battery 7. The metering circuitry 9 is arranged in parallel to the capacitor 13 and simply shown as a resistive load 9. The circuit 12 has the effect of minimizing peak currents drawn from the battery 7. Minimizing peak currents has the effect that self-discharge is minimized since high peak currents will reduce the internal resistance of the battery 7.

Due to the dimensions of the parts of the circuit 12, the battery 7 essentially only charges the capacitor 13. The maximum current for charging the capacitor 13 is determined by the size of the resistor 14. Therefore, the peak current drawn from the battery 7 is well-defined which limits the reduction of the internal resistance of the battery 7 by high peak currents and thus the the self-discharge of the battery 7. The current required to operate the metering circuitry 9 and other components of the meter 2 such as a radio or a display is provided by the capacitor 13.

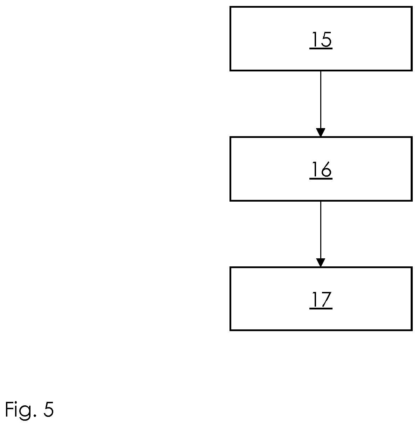

Operation of the exemplary embodiments of a consumption meter system 1 will now be described with reference to the flow chart shown in Figure 5.

In a first step 15 the accumulation module 10 of the consumption meter accumulates a first quantity to obtain a first accumulated quantity. Here, the first quantity is a product of the current drawn by the metering circuitry 9 and other components of the consumption meter 2 from the battery 7 and the time for which the current was drawn from the battery 7.

In the exemplary embodiments, the consumption meters 2 can only perform a limited and well-known number of operations. For example, each consumption meter 2 can perform a consumption measurement. For example, in case the consumption meter 2 is a water meter, the meter 2 measures the flow of water. In case the consumption meter 2 is a heat meter, it measures the thermal energy by a heat transfer fluid by determining the flow rate of the heat transfer fluid and the temperature difference between the inlet/forward flow and the outlet/return flow of the heat transfer fluid.

These measurement operations consume a well-defined amount of current over a well-defined amount of time. Therefore, instead of measuring the current drawn from the battery and the time for which the current is drawn from the battery, for every metering operation the accumulation module reads a first quantity from a register or memory and adds this current-time-value to the first accumulated quantity.

In a similar manner, also the first quantity or current-time or current-hours required for transmitting the first accumulated quantity to the base station 4 or, to be more precise, to the accumulation module 3, as well as the current-time required for the display is turned on for showing the values measured and other information regarding the consumption meter 2 are well-known quantities and can be stored in a memory of the meter 2. Whenever an operation is performed, the respective values are read from the memory and added to the first accumulated value. Some operations such as the transmission time may require different amounts of time. Therefore, for these operations only a current value per unit of time is stored in the memory and the meter 2 has to determine the time for which the operations are performed to obtain the respective first quantities.

The current consumption and thus the first quantity depends on the temperature inside the meter 2. Therefore, the memory of the meter provides different current-time-values depending on the last temperature sensed by the temperature sensor 11. Alternatively, the accumulation module 10 may correct the respective first quantities read from the memory by applying a temperature correction factor before accumulating the first quantities.

According to the exemplary embodiment of method shown in Figure 5, the first accumulated quantity is never reset during the lifetime of the meter. In other words, whenever a new operation is performed by the meter, the corresponding current-time value is added to the first accumulated quantity.

In a second step 16, the consumption meter 2 also accumulates a second quantity which is a product of a temperature sensed using the temperature sensor 11 of the consumption meter 2 and a time for which the temperature was sensed. In the exemplary embodiment, the temperature is sensed every 1 minute and the corresponding temperature-time value or the corresponding temperature-hours are added to the second accumulated value. Also, the second accumulated quantity is never reset during operation of the meter 2, i.e., over the lifetime of the meter 2 the second accumulated value increases, for example, every twelve hours or at least at every instance a new temperature-time value is added to the second accumulated quantity.

When the first and second quantities have been accumulated for a certain time period, the first and second accumulated quantities are transmitted to the battery lifetime estimation module 3 at the base station 4 in a third step 17. The transmission of the first and second accumulated quantities may occur at regular intervals, for example, once per week. However, in the present embodiment the first accumulated quantity is transmitted once per week, whereas the second accumulated quantity is transmitted once every twelve hours. In other words, the first and second accumulated quantities are transmitted at different but regular intervals.

It should be noted that the transmission may also occur at irregular intervals. For example, transmission may be triggered by a user or operator at the consumption meter 2 or transmission may be triggered by other factors. In the exemplary embodiment, the second accumulated quantity is always transmitted to the battery lifetime estimation module when a temperature change of more than 10°C has been observed to ensure that temperature that have a relevant influence on the self-discharge of the battery are taken into consideration at the battery lifetime estimation module.

With the first and second accumulated quantities further information may be transmitted from the consumption meter 2 to the battery lifetime estimation module 3. For example, a timestamp may be transmitted which gives an indication of the overall runtime of the meter 2 or simply indicates the time at which the last addition was made to the transmitted first and/or second quantity. Furthermore, the consumption meter 2 may also transmit an identifier such as a serial number to the battery lifetime estimation. Additional information may also be transmitted using separate transmission. Additional information could be a change of the battery 7, a change of an operating mode of the meter 2, when the meter 2 is placed or retrieved from storage, installed at a metering location, undergoes maintenance, or is recalibrated. Further, the peak discharge of the battery 7 could also be transmitted from the meter 2 to the base station 4.

Data transmission may be performed using a proprietary or a standardized wireless communication protocol, such as wireless M-Bus according to EN13757, LoRa, LoRa WAN, Zigbee, Sigfox, Bluetooth. Alternatively, the data transmission may be effectuated using cellular communication infrastructures especially LTE cat. M or LTE cat. NB (Narrow band loT). As an alternative a wired communication protocol may be used such as wired M-Bus EN13757, LON, BACnet, Modbus or a proprietary wired protocol.

At the battery lifetime estimation module 3, a remaining battery lifetime is estimated from the received first and second accumulated quantities. The estimate may, for example, be updated automatically whenever a new accumulated quantity is received, be calculated at given intervals and/or determined upon request by a user or operator.

The remaining battery lifetime estimation module 3 uses inter alia the received first and second accumulated quantities as well as a nominal battery capacity and an operating time of the battery 7 to estimate the remaining battery runtime. In the present example, the battery lifetime estimation module 3 determines a correction factor which is applied to the nominal battery capacity before subtracting an estimated battery usage therefrom to obtain a remaining battery capacity. The remaining battery capacity is divided by an expected future discharge to calculate the remaining battery lifetime.

The correction factor is used to correct the nominal battery capacity for self-discharge. Self-discharge depends on the type of battery 7 (which may also be transmitted by the meter 2) and, for example, the peak current supplied by the battery 7 as well as the temperature at the meter 2. Thus, the second accumulated quantity is used to determine the correction factor. To this end, the difference or delta between subsequent second accumulated quantities is calculated and average temperature for the time between the subsequent transmission is determined. These average values are sorted into bins. The temperature distribution at the meter 2 derived in this way is used to determine the correction factor.

Once the correction factor has been applied to the nominal battery capacity, the received first accumulated quantity can be subtracted from the corrected battery capacity. It is self-evident that it may be necessary to modify the received first accumulated quantity to ensure that the corrected battery capacity and the first accumulated quantity are provided in identical units. Furthermore, in case the received first accumulated quantity does not already account for a temperature-dependence of the current consumption at the meter 2, the received first accumulated quantity may also be corrected based on the received second accumulated quantity.

It should be noted that it may be necessary to exclude certain received first and second accumulated quantities. In particular, in case the battery 7 of the meter 2 has been changed without resetting the first and second accumulated quantities at the meter2, those quantities that were recorded for previous batteries have to be excluded.

The remaining battery capacity is divided by an expected future discharge of the battery to obtain a remaining battery lifetime. In the exemplary embodiment, the expected future discharge is estimated based on the received first and second accumulated quantities and the peak current drawn from the battery. However, only first and second accumulated quantities received during the last 12 months are considered and first and second accumulated quantities obtained while the meter 2 was in storage or being recalibrated are excluded when estimating the expected future discharge. Thereby, it is ensured that times at which the meter does not operate under regular conditions are ignored.

Finally, in a further exemplary embodiment shown in Figure 4, a base station 4 with a battery estimation module 3 is provided that is configured for estimating the remaining battery lifetime of a plurality of consumption meters 2. To this end, each of the consumption meters 2 transmits a first and a second accumulated quantity to the battery lifetime estimation module 3. The operation and structure of the meters 2 and the battery lifetime estimation module 3 in Figure 4 corresponds to the operation and structure of the devices shown in Figure 1. Each combination of a meter 2 in Figure 4 and the battery lifetime estimation module 3 thus forms a consumption meter system.

### List of reference numerals

- 1: consumption meter system
- 2: consumption meter
- 3: battery lifetime estimation module
- 4: base station
- 5: antenna
- 6: antenna
- 7: battery
- 8: meter housing
- 9: metering circuitry
- 10: accumulation module
- 10a: microcontroller
- 11: temperature sensor
- 12: circuit
- 13: capacitor
- 14: resistor/
- 15: first method step
- 16: second method step
- 17: third method step

## Claims

1. Consumption meter (2) comprising a battery (7) for energy supply, a temperature sensor (2) and an accumulation module (10),
wherein the accumulation module (10) is configured for accumulating a first quantity over a time period to obtain a first accumulated quantity, wherein the first quantity is based on a product of at least a current drawn from the battery and a duration over which the current was drawn from the battery (7), and
wherein the accumulation module (10) is further configured for transmitting the first accumulated quantity at regular or irregular intervals to a battery lifetime estimation module for calculating a remaining battery lifetime on basis of a nominal battery capacity, the received first accumulated quantity and an operating time of the battery (7),
**characterized in that** the accumulation module (10) is configured for accumulating a second quantity over a time period to obtain a second accumulated quantity, wherein the second quantity is a product of a temperature at the consumption meter (2) and a duration for which the temperature was observed, and for transmitting the second accumulated quantity to the battery lifetime estimation module (3) for calculating a remaining battery lifetime additionally based on the received second accumulated quantity.

2. Consumption meter (2) according to claim 1, wherein the first quantity is based at least on a product of the current drawn from the battery (7) and the duration over which the current was drawn from the battery (7) and preferably also a voltage at which the current was supplied from the battery (7).

3. Consumption meter (2) according to claim 1 or 2, wherein the accumulation module (10) is configured for estimating the first quantity based on an operation of the consumption meter (2) or
wherein the consumption meter (2) comprises means for measuring the current drawn from the battery (7), wherein the consumption meter (2) preferably comprises means for measuring a voltage at which the current is supplied by the battery (7) and/or means for measuring the duration over which the current is drawn from the battery (7).

4. Consumption meter (2) according to any of the preceding claims, wherein the accumulation module (10) is further configured for determining the first quantity based on a temperature sensed by the temperature sensor (11).

5. Consumption meter (2) according to any of the preceding claims, wherein the accumulation module (10) is configured for accumulating the one or more quantities from the time the battery (7) is initially placed in the consumption meter (2) until the battery (7) is removed from the consumption meter (2) or
Wherein the accumulation module (10) is configured for accumulating the one or more quantities over the entire lifetime of the consumption meter (2).

6. Consumption meter system (1) comprising a consumption meter (2) according to any of the preceding claims and a battery lifetime estimation module (3),
wherein said battery lifetime estimation module (3) is configured for receiving the first accumulated quantity from the accumulation module (10) and calculating a remaining battery lifetime on basis of a nominal battery capacity, the received first accumulated quantity and an overall operating time of the battery (7).

7. Consumption meter system (1) according to claim 6, wherein the battery lifetime estimation module (3) is configured for calculating the remaining battery lifetime by subtracting the first accumulated quantity last received from an available battery capacity to obtain a remaining battery capacity and estimating the remaining battery life by dividing the remaining battery capacity by an expected future discharge of the battery (7).

8. Consumption meter system (1) according to claim 7, wherein the battery lifetime estimation module (3) is configured for estimating the available battery capacity by applying a correction factor to the nominal battery capacity,
wherein the battery lifetime estimation module (3) is preferably configured for calculating an average current drawn from the battery based on the received first accumulated quantity and determining the correction factor for estimating the available battery capacity based on the calculated average current and/or
wherein the battery lifetime estimation module (3) is preferably configured for determining the correction factor based on a peak current drawn from the battery (7).

9. Consumption meter system (1) according to any of claims 6 to 8 comprising a consumption meter (2) according to claim 4, wherein the battery lifetime estimation module (3) is configured for receiving the second accumulated quantity from the accumulation module (10) and calculating a remaining battery lifetime also on basis of the received second accumulated quantity,
wherein the battery lifetime estimation module (3) is preferably configured for correcting a received first accumulated value based on a received second accumulated value to account for temperature-dependent current consumption and/or
wherein the battery lifetime estimation module (3) is preferably configured for determining the correction factor based on the received second accumulated quantity.

10. Consumption meter system (1) according to claims 9, wherein the battery lifetime estimation module (3) is configured for calculating the correction factor based on all second accumulated quantities received since the battery (7) has been placed in the meter.

11. Consumption meter system (1) according to any of claims 6 to 10, wherein the battery lifetime estimation module (3) is configured for estimating the expected future discharge based on at least some of the received first accumulated quantities and preferably by estimating the expected future discharge from selected received first accumulated quantities,
wherein further preferably an average of at least some of the received first accumulated quantities is determined.

12. Consumption meter system (1) according to claim 11, wherein the battery lifetime estimation module (3) is configured for excluding at least some of the received first and/or second accumulated quantities when estimating the expected future discharge.

13. Consumption meter system (1) according to any of claims 6 to 12, wherein the consumption meter (1) comprises the battery lifetime estimation module (3).

14. Consumption meter system (1) according to any of claims 6 to 12, wherein the battery lifetime estimation module (3) is part of an external control device which is arranged remotely from the consumption meter (2).

15. Consumption meter system (1) according to claim 14, wherein the battery lifetime estimation module (3) is configured to estimate the remaining battery lifetime of the batteries (7) of a plurality of consumption meters (2).

## Patentansprüche

1. Verbrauchszähler (2), aufweisend eine Batterie (7) zur Stromversorgung, einen Temperatursensor (2) und ein Sammelmodul (10),
wobei das Sammelmodul (10) so eingerichtet ist, dass es eine erste Größe über einen Zeitraum hinweg sammelt, um eine erste gesammelte Größe zu erlangen, wobei die erste Größe auf einem Produkt wenigstens eines Stroms, der von der Batterie gezogen wurde, und einer Dauer, für die der Strom von der Batterie (7) gezogen wurde, beruht, und
wobei das Sammelmodul (10) ferner so eingerichtet ist, dass es die erste gesammelte Größe in regelmäßigen oder unregelmäßigen Intervallen an ein Batterielebensdauer-Schätzmodul sendet, um auf der Grundlage einer Nennkapazität der Batterie, der erhaltenen ersten gesammelten Größe und einer Betriebszeit der Batterie (7) eine verbleibende Batterielebensdauer zu berechnen,
**dadurch gekennzeichnet, dass** das Sammelmodul (10) so eingerichtet ist, dass es eine zweite Größe über einen Zeitraum hinweg sammelt, um eine zweite gesammelte Größe zu erlangen, wobei die zweite Größe ein Produkt einer Temperatur an dem Verbrauchszähler (2) und einer Dauer, für die die Temperatur beobachtet wurde, ist, und die zweite gesammelte Größe an das Batterielebensdauer-Schätzmodul (3) sendet, um eine verbleibende Batterielebensdauer zu berechnen, die zusätzlich auf der erhaltenen zweiten gesammelten Größe beruht.

2. Verbrauchszähler (2) nach Anspruch 1, wobei die erste Größe auf wenigstens einem Produkt des Stroms, der von der Batterie (7) gezogen wurde, und der Dauer, für die der Strom von der Batterie (7) gezogen wurde, und vorzugsweise auch einer Spannung, mit der der Strom von der Batterie (7) geliefert wurde, beruht.

3. Verbrauchszähler (2) nach Anspruch 1 oder 2, wobei das Sammelmodul (10) so eingerichtet ist, dass es die erste Größe auf der Grundlage eines Betriebs des Verbrauchszählers (2) schätzt, oder
wobei der Verbrauchszähler (2) Mittel zum Messen des Stroms, der von der Batterie (7) gezogen wird, aufweist, wobei der Verbrauchszähler (2) vorzugsweise Mittel zum Messen einer Spannung, mit der der Strom von der Batterie (7) geliefert wird, und/oder Mittel zum Messen der Dauer, für die der Strom von der Batterie (7) gezogen wird, aufweist.

4. Verbrauchszähler (2) nach einem der vorhergehenden Ansprüche, wobei das Sammelmodul (10) ferner so eingerichtet ist, dass es die erste Größe auf der Grundlage einer Temperatur, die durch den Temperatursensor (11) erfasst wurde, bestimmt.

5. Verbrauchszähler (2) nach einem der vorhergehenden Ansprüche, wobei das Sammelmodul (10) so eingerichtet ist, dass es die eine oder die mehreren Größen ab dem Zeitpunkt, zu dem die Batterie (7) anfänglich in den Verbrauchszähler (2) eingesetzt wurde, bis zu der Entnahme der Batterie (7) aus dem Verbrauchszähler (2) sammelt, oder
wobei das Sammelmodul (10) so eingerichtet ist, dass es die eine oder die mehreren Größen über die gesamte Lebensdauer des Verbrauchszählers (2) hinweg sammelt.

6. Verbrauchszählersystem (1), aufweisend einen Verbrauchszähler (2) nach einem der vorhergehenden Ansprüche und ein Batterielebensdauer-Schätzmodul (3),
wobei das Batterielebensdauer-Schätzmodul (3) so eingerichtet ist, dass es von dem Sammelmodul (10) die erste gesammelte Größe erhält und auf der Grundlage einer Nennkapazität der Batterie, der erhaltenen ersten gesammelten Größe und einer gesamten Betriebszeit der Batterie (7) eine verbleibende Batterielebensdauer berechnet.

7. Verbrauchszählersystem (1) nach Anspruch 6, wobei das Batterielebensdauer-Schätzmodul (3) so eingerichtet ist, dass es die verbleibende Batterielebensdauer durch Subtrahieren der zuletzt erhaltenen ersten gesammelten Größe von einer verfügbaren Kapazität der Batterie, um eine verbleibende Kapazität der Batterie zu erlangen, und Schätzen der verbleibenden Batterielebensdauer durch Teilen der verbleibenden Kapazität der Batterie durch eine voraussichtliche zukünftige Entladung der Batterie (7) berechnet.

8. Verbrauchszählersystem (1) nach Anspruch 7, wobei das Batterielebensdauer-Schätzmodul (3) so eingerichtet ist, dass es die verfügbare Kapazität der Batterie durch Anwenden eines Korrekturfaktors auf die Nennkapazität der Batterie schätzt,
wobei das Batterielebensdauer-Schätzmodul (3) vorzugsweise so eingerichtet ist, dass es auf der Grundlage der erhaltenen ersten gesammelten Größe einen durchschnittlichen Strom, der von der Batterie gezogen wurde, berechnet und den Korrekturfaktor zum Schätzen der verfügbaren Kapazität der Batterie auf der Grundlage des berechneten durchschnittlichen Stroms bestimmt, und/oder
wobei das Batterielebensdauer-Schätzmodul (3) vorzugsweise so eingerichtet ist, dass es den Korrekturfaktor auf der Grundlage eines von der Batterie (7) gezogenen Spitzenstroms bestimmt.

9. Verbrauchszählersystem (1) nach einem der Ansprüche 6 bis 8, aufweisend einen Verbrauchszähler (2) nach Anspruch 4, wobei das Batterielebensdauer-Schätzmodul (3) so eingerichtet ist, dass es die zweite gesammelte Größe von dem Sammelmodul (10) erhält und eine verbleibende Batterielebensdauer auch auf der Grundlage der erhaltenen zweiten gesammelten Größe berechnet,
wobei das Batterielebensdauer-Schätzmodul (3) vorzugsweise so eingerichtet ist, dass es einen erhaltenen ersten gesammelten Wert auf der Grundlage eines erhaltenen zweiten gesammelten Werts korrigiert, um einen temperaturabhängigen Stromverbrauch zu berücksichtigen, und/oder
wobei das Batterielebensdauer-Schätzmodul (3) vorzugsweise so eingerichtet ist, dass es den Korrekturfaktor auf der Grundlage der erhaltenen zweiten gesammelten Größe bestimmt.

10. Verbrauchszählersystem (1) nach Anspruch 9, wobei das Batterielebensdauer-Schätzmodul (3) so eingerichtet ist, dass es den Korrekturfaktor auf der Grundlage aller zweiten gesammelten Größen, die seit dem Einsetzen der Batterie (7) in den Zähler erhalten wurden, berechnet.

11. Verbrauchszählersystem (1) nach einem der Ansprüche 6 bis 10, wobei das Batterielebensdauer-Schätzmodul (3) so eingerichtet ist, dass es die voraussichtliche zukünftige Entladung auf der Grundlage wenigstens einiger der erhaltenen ersten gesammelten Größen und vorzugsweise durch Schätzen der voraussichtlichen zukünftigen Entladung aus ausgewählten erhaltenen ersten gesammelten Größen schätzt,
wobei ferner vorzugsweise ein Durchschnitt wenigstens einiger der erhaltenen ersten gesammelten Größen bestimmt wird.

12. Verbrauchszählersystem (1) nach Anspruch 11, wobei das Batterielebensdauer-Schätzmodul (3) so eingerichtet ist, dass es bei dem Schätzen der voraussichtlichen zukünftigen Entladung wenigstens einige der erhaltenen ersten und/oder zweiten gesammelten Größen ausschließt.

13. Verbrauchszählersystem (1) nach einem der Ansprüche 6 bis 12, wobei der Verbrauchszähler (1) das Batterielebensdauer-Schätzmodul (3) aufweist.

14. Verbrauchszählersystem (1) nach einem der Ansprüche 6 bis 12, wobei das Batterielebensdauer-Schätzmodul (3) Teil einer externen Steuervorrichtung ist, die von dem Verbrauchszähler (2) entfernt eingerichtet ist.

15. Verbrauchszählersystem (1) nach Anspruch 14, wobei das Batterielebensdauer-Schätzmodul (3) so eingerichtet ist, dass es die verbleibende Batterielebensdauer der Batterien (7) von mehreren Verbrauchszählern (2) schätzt.

## Revendications

1. Compteur de consommation (2) comprenant une batterie (7) pour l'alimentation en énergie, un capteur de température (2) et un module d'accumulation (10),
dans lequel le module d'accumulation (10) est configuré pour accumuler une première quantité sur une période de temps afin d'obtenir une première quantité accumulée, dans lequel la première quantité est basée sur un produit d'au moins un courant soutiré de la batterie et d'une durée pendant laquelle le courant a été soutiré de la batterie (7), et
dans lequel le module d'accumulation (10) est en outre configuré pour transmettre la première quantité accumulée à intervalles réguliers ou irréguliers à un module d'estimation de la durée de vie de batterie afin de calculer une durée de vie restante de batterie sur la base d'une capacité nominale de batterie, de la première quantité accumulée reçue et d'une durée de fonctionnement de la batterie (7),
**caractérisé en ce que** le module d'accumulation (10) est configuré pour accumuler une deuxième quantité sur une période de temps afin d'obtenir une deuxième quantité accumulée, dans lequel la deuxième quantité est un produit d'une température au niveau du compteur de consommation (2) et d'une durée pendant laquelle la température a été observée et pour transmettre la deuxième quantité accumulée au module d'estimation de durée de vie de batterie (3) pour le calcul d'une durée de vie restante de batterie sur la base en outre de la deuxième quantité accumulée reçue.

2. Compteur de consommation (2) selon la revendication 1, dans lequel la première quantité est basée au moins sur un produit du courant qui a été soutiré de la batterie (7) et de la durée pendant laquelle le courant a été soutiré de la batterie (7), et de préférence également sur une tension à laquelle le courant a été fourni par la batterie (7).

3. Compteur de consommation (2) selon la revendication 1 ou 2, dans lequel le module d'accumulation (10) est configuré pour estimer la première quantité sur la base du fonctionnement du compteur de consommation (2) ou
dans lequel le compteur de consommation (2) comprend des moyens pour mesurer le courant soutiré de la batterie (7), dans lequel le compteur de consommation (2) comprend de préférence des moyens pour mesurer la tension à laquelle le courant est fourni par la batterie (7) et/ou des moyens pour mesurer la durée pendant laquelle le courant est soutiré de la batterie (7).

4. Compteur de consommation (2) selon une quelconque des revendications précédentes, dans lequel le module d'accumulation (10) est en outre configuré pour déterminer la première quantité sur la base d'une température détectée par le capteur de température (11).

5. Compteur de consommation (2) selon une quelconque des revendications précédentes, dans lequel le module d'accumulation (10) est configuré pour accumuler une ou plusieurs quantités depuis le moment où la batterie (7) est initialement placée dans le compteur de consommation (2) jusqu'à ce que la batterie (7) soit retirée du compteur de consommation (2) ou
dans lequel le module d'accumulation (10) est configuré pour accumuler une ou plusieurs quantités sur toute la durée de vie du compteur de consommation (2).

6. Système de compteur de consommation (1) comprenant un compteur de consommation (2) selon une quelconque des revendications précédentes et un module d'estimation de durée de vie de batterie (3),
dans lequel ledit module d'estimation de durée de vie de batterie (3) est configuré pour recevoir la première quantité accumulée du module d'accumulation (10) et calculer une durée de vie restante de batterie sur la base d'une capacité nominale de batterie, de la première quantité accumulée reçue et d'une durée de fonctionnement totale de la batterie (7).

7. Système de compteur de consommation (1) selon la revendication 6, dans lequel le module d'estimation de durée de vie de batterie (3) est configuré pour calculer la durée de vie restante de batterie en soustrayant la première quantité accumulée reçue en dernier d'une capacité de batterie disponible afin d'obtenir une capacité restante de batterie et estimer la durée de vie restante de batterie en divisant la capacité restante par une décharge future escomptée de la batterie (7).

8. Système de compteur de consommation (1) selon la revendication 7, dans lequel le module d'estimation de durée de vie de batterie (3) est configuré pour estimer la capacité de batterie disponible en appliquant un facteur de correction à la capacité nominale de batterie,
dans lequel le module d'estimation de durée de vie de batterie (3) est de préférence configuré pour calculer un courant moyen soutiré de la batterie sur la base de la première quantité accumulée reçue et pour déterminer le facteur de correction permettant d'estimer la capacité de batterie disponible sur la base du courant moyen calculé et/ou
dans lequel le module d'estimation de durée de vie de batterie (3) est de préférence configuré pour déterminer le facteur de correction sur la base d'un courant de crête soutiré de la batterie (7).

9. Système de compteur de consommation (1) selon une quelconque des revendications 6 à 8, comprenant un compteur de consommation (2) selon la revendication 4, dans lequel le module d'estimation de durée de vie de batterie (3) est configuré pour recevoir la deuxième quantité accumulée du module d'accumulation (10) et calculer une durée de vie restante de batterie également sur la base de la deuxième quantité accumulée reçue,
dans lequel le module d'estimation de durée de vie de batterie (3) est de préférence configuré pour corriger une première valeur accumulée reçue sur la base d'une deuxième valeur accumulée reçue afin de tenir compte de la consommation de courant dépendante de la température et/ou
dans lequel le module d'estimation de durée de vie de batterie (3) est de préférence configuré pour déterminer le facteur de correction sur la base de la deuxième valeur accumulée reçue.

10. Système de compteur de consommation (1) selon la revendication 9, dans lequel le module d'estimation de durée de vie de batterie (3) est configuré pour calculer le facteur de correction sur la base de toutes les deuxièmes valeurs accumulées reçues depuis que la batterie (7) a été placée dans le compteur.

11. Système de compteur de consommation (1) selon une quelconque des revendications 6 à 10, dans lequel le module d'estimation de durée de vie de batterie (3) est configuré pour estimer la décharge future escomptée sur la base d'au moins certaines des premières valeurs accumulées reçues et de préférence en estimant la décharge future escomptée à partir de de certaines des premières valeurs accumulées reçues,
dans lequel, de préférence, une moyenne d'au moins certaines des premières valeurs accumulées reçues est déterminée.

12. Système de compteur de consommation (1) selon la revendication 11, dans lequel le module d'estimation de durée de vie de batterie (3) est configuré pour ignorer au moins une partie des premières et/ou deuxièmes quantités accumulées reçues lors de l'estimation de la décharge future escomptée.

13. Système de compteur de consommation (1) selon une quelconque des revendications 6 à 12, dans lequel le compteur de consommation (1) comprend le module d'estimation de durée de vie de batterie (3).

14. Système de compteur de consommation (1) selon une quelconque des revendications 6 à 12, dans lequel le module d'estimation de durée de vie de batterie (3) fait partie d'un dispositif de commande externe qui est disposé à distance du compteur de consommation (2).

15. Système de compteur de consommation (1) selon la revendication 14, dans lequel le module d'estimation de durée de vie de batterie (3) est configuré pour estimer la durée de vie restante des batteries (7) d'une pluralité de compteurs de consommation (2).
